**Europäisches Patentamt**

**European Patent Office**

**Office européen des brevets**

(19)

(11) Publication number: **0 041 850 B2**

(12)

# NEW EUROPEAN PATENT SPECIFICATION

(45) Date of publication of the new patent specification: **22.03.89**

(51) Int. Cl.⁴: **C 23 C 14/22, C 08 J 7/04**

(21) Application number: **81302513.7**

(22) Date of filing: **05.06.81**

(54) A method of vacuum depositing a layer on a plastics film substrate.

(30) Priority: **10.06.80 JP 78609/80**
**10.06.80 JP 78593/80**

(43) Date of publication of application:
**16.12.81 Bulletin 81/50**

(45) Publication of the grant of the patent:
**04.09.85 Bulletin 85/36**

(45) Mention of the opposition decision:
**22.03.89 Bulletin 89/12**

(84) Designated Contracting States:
**DE FR GB**

(56) References cited:
**DE-A- 2 233 258**
**DE-A- 2 446 487**
**FR-A- 775 783**
**FR-A- 1 181 426**
**GB-A- 1 368 454**
**GB-A- 1 448 518**
**US-A- 3 046 936**
**US-A- 3 588 308**
**US-A- 3 632 443**

(73) Proprietor: **Matsushita Electric Industrial Co., Ltd., 1006, Oaza Kadoma, Kadoma-shi Osaka-fu, 571 (JP)**

(72) Inventor: **Shinohara, Koichi, 6-8-305, Okamoto 4-chome, Higashinada-ku Kobe-shi Hyogo-ken (JP)**
Inventor: **Fujita, Takashi, 3-212-404, Seiwadaihigashi 4-chome, Kawanishi-shi Hyogo-ken (JP)**

(74) Representative: **Crawford, Andrew Birkby et al, A.A. THORNTON & CO. Northumberland House 303-306 High Holborn, London WC1V 7LE (GB)**

EP 0 041 850 B2

## Description

This invention relates to a method of vacuum depositing a layer on a substrate of a plastics film, and more particularly relates to a method and apparatus suitable for continuously depositing a layer on a continuous length of film while the film is transported in a longitudinal direction.

During a deposition process, a substrate is raised in temperature to a fairly high degree by, for example, radiant heat from an evaporation source or latent heat due to deposition of an evaporated substance. Therefore, when a plastics film is used as the substrate, it is necessary to control the temperature of the film so as not to exceed a given value, thereby avoiding thermal damage to the film.

In order to control the temperature of the film, it has previously been proposed to transport the film around the peripheral surface of a metal cylinder and control the deposition of the evaporated substance so as to be deposited on the portion of the film in contact with the metal surface, so that the heat in the film is dissipated by the cylinder.

US-A 3 046 936 shows a method of vacuum depositing a layer on a plastics film in which the film is transported so as to pass along a heat conductive surface, e.g. a metal cylinder movable whith the film. The material to be deposited is heated and evaporated by an electron beam bombardment, the electron beam having a high power of up to 60 kW.

However the cooling effect of the cylinder has not been sufficient to avoid thermal damage to the film when a fairly thick layer of a high melting point metal is being deposited, when the deposition rate is high, or when the thickness of the substrate film is fairly small.

DE-A 2 233 258 discloses a method of improving the contact between a plastics film to be coated with a metal and a cooling drum of a vacuum deposition chamber by means of electrostatic forces.

It is an object of this invention to provide a method of continuously vacuum depositing a layer on a moving plastics film in which the temperature of the film during deposition is controlled effectively.

According to this invention there is provided a method for vacuum depositing a layer on a plastics film in which said film is transported so as to pass along a heat conductive surface movable with the film and deposition is carried out in a vacuum chamber in such a manner that a vapour of a source material is emitted to the portion of said film in contact with said heat conductive surface, said source material being heated and evaporated by electron beam bombardment, characterized in that said heat conductive surface has a surface roughness smaller than 0.1 μm and in that said film is made to exhibit an electret state in the vacuum chamber for the deposition process and has a surface potential higher than 150 V when it is in contact with said heat conductive surface, whereby an electrostatic force exists between said film and said heat conductive surface, the energy of said electrons in said electron beam being high enough to cause an electron reflected from said source material to be implanted into the film.

Features and advantages of the present invention will become apparent from the following description of an embodiment thereof given by way of example with reference to the accompanying drawings, in which:

Figure 1 is an elevational view in section of an example of a deposition apparatus for carrying out a method according to the present invention;

Figures 2A and 2B are photographs taken through a microscope of surfaces of deposited layer formed by a method according to the invention and by a previously proposed technique, respectively;

Figure 3 is a graph showing the relationship between surface potential of a substrate during deposition and the maximum thickness of a deposited layer obtainable in crak free state; and

Figure 4 is a graph showing the relationship between a time for exposing a substrate to a glow discharge after deposition and a frequency blocking occurrence.

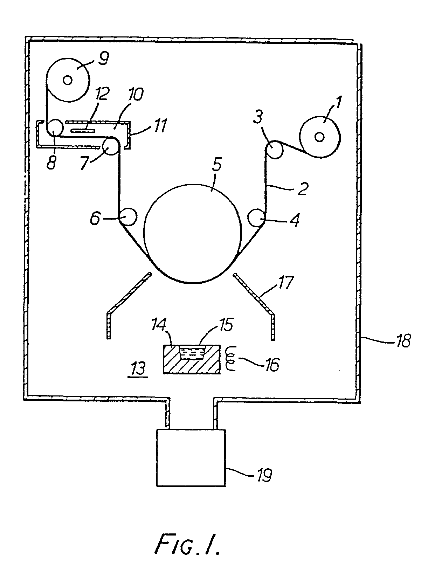

Figure 1 shows a example of a deposition apparatus for carrying out a method according to the present invention. Plastics film 2 is drawn off a supply reel 1 and guided by rollers 3 and 4 on the periphery of a rotatable cylindrical drum 5 whose surface is made of metal and grounded. After transport along the peripheral surface of the drum 5, the film 2 is guided by rollers 6, 7 and 8 to a take-up reel 9. Between the rollers 7 and 8 the film 2 passes through a glow discharge chamber 10 which is formed by a partition 11. A glow discharge electrode 12 is provided in the glow discharge chamber 10. Between the rollers 7 and 8 and the partition 11 are provided sealing means which are not shown in the Figure.

Adjacent the drum 5 at the location where it contacts the film 2, there is placed an evaporation source 13 which includes a water-cooled copper hearth 14 containing a charge of an evaporation source material 15. The source material 15 is heated and evaporated by an electron beam emitted from an electron beam source 16, so as to be deposited on the film 2. A shield plate 17 is provided for limiting an area to which the vapour of the source material 15 is emitted.

The above-mentioned apparatus is contained in a vacuum chamber 18 which is evacuated by an evacuation system 19.

By using the above-mentioned apparatus, deposition is carried out as the film 2 is transported from the reel 1 to the reel 9, so that a layer of the material 15 is continuously deposited on the film 2.

The film 2 is in an electret state at least when it is located in contact with the peripheral surface of the drum 5. This causes an electrostatic attractive force between the film 2 and the drum 5, which effects an intimate contact between the film 2 and the drum 5. Thereby heat in the film 2 is dissipated into the drum 5 by conduction at an improved high efficiency. A deposited metal or semiconductor layer improves the intimate contact between the film 2 and the drum 5 because it makes uniform the electrostatic field imparted by the static charge in the film 2.

When an electron beam is used for heating the source material as shown in Figure 1, the film can be made to exhibit electret properties by using an electron beam having high energy such as 20 keV to 60 keV. Such energy levels are fairly high compared with that supplied in an ordinary deposition process. Thus an electron reflected by the source material 15 is implanted into the film 2 and so a static charge is stored therein, which makes an electro-electret. The quantity of charge required for making the film exhibit electret state and/or the requisite decay rate may be determined according to an object of deposition.

The means for cooling the film 2 is not limited to the drum 5 as mentioned above. The necessary requirement is a structure having a metal surface arranged to contact the film and be movable with the film.

The cooling effect is not influenced by introduction of a gas into the vacuum chamber 18.

Thus the temperature rise of the substrate film due to deposition is notably alleviated and so it is possible to deposit a fairly thick layer on a plastics film at a high deposition rate.

However, if the film on which the deposition layer is formed by the method as mentioned above is wound around the take-up reel 9, the electrostatic charge causes difficulties such as generation of creases, peeling of the deposition layer or tearing of the substrate film on unwinding due to blocking, etc. These are especially severe in the case where the substrate is thin and long and has a smooth surface.

In order to prevent such difficulties the electret charge is neutralized after the deposition process. An example thereof is shown in Figure 1 in which the surface of the film 2 opposite to that on which the deposited layer is formed is exposed to a glow discharge by the electrode 12. The glow discharge is achieved by introducing a suitable gas such as $O_2$, $N_2$ or Ar into the glow discharge chamber 10 and supplying and AC voltage to the electrode 12. Any other conventional glow discharge means may be used. Also it is possible to use other methods of neutralizing the charge such as irradiating the surface of the film opposite to the deposited layer with ions from an ion generator.

The effect obtained by making a substrate film exhibit electret state was examined in cases where the substrate film was made of polyester, polyimide, polypropylene, polyethylene terephthalate, polyethylene terenaphthalate, polymide, polycarbonate, polyvinyl chloride, polyvinyl acetate, polyacrylonitrile of polymethacrylate, and the evaporation source material used was Al, Si, Ti, Ag, Co, Cr, Ni, V, W, Mo, Fe, NiCr or other alloys. As a result of experiments using depositions of thicknesses from 0.01 to 0.6 μm, it was observed that a deposition thickness exceeding about 0.15 to 0.2 μm, there were significant differences between the case using an electret state substrate and the case using an ordinary substrate in so far as generation of creases and thermal damage of the substrate were concerned.

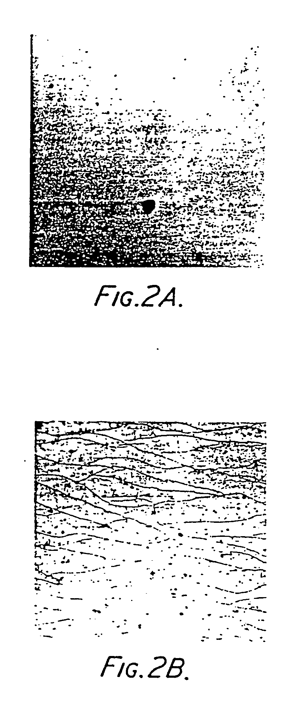

Figures 2A and 2B show photographs taken through a microscope at a magnification of ×200 of layers deposited on a substrate exhibiting the electret state and an ordinary substrate, respectively. The photograph shown in Figure 2A was obtained by deposition Cr to a thickness of 0.5 μm on a polyethylene terephthalate film 4 μm thick when the film was exhibiting an electret state having a surface potential of 100 V, with the film being transported at a speed of 20 m/min. The photograph shown in Figure 2B was obtained by depositing a thickness of 1.5 μm on a ordinary film, with the other conditions being the same as in the case of Figure 2A. In Figure 2B, there are observed a fairly large number of cracks, in spite of the thickness of the deposited layer being three times larger than that in Figure 2A.

An attempt was made to deposit a 0.5 μm layer using a ordinary substrate, but such substrates having thicknesses from 4 to 12 μm were melted partially. In order to obtain a crack free layer as shown in Figure 2A by using an ordinary state substrate 20 μm thick, the thickness of the deposited layer had to be less than 0.12 μm. These tendencies were observed irrespectively of the type of substrate material and the type of source material.

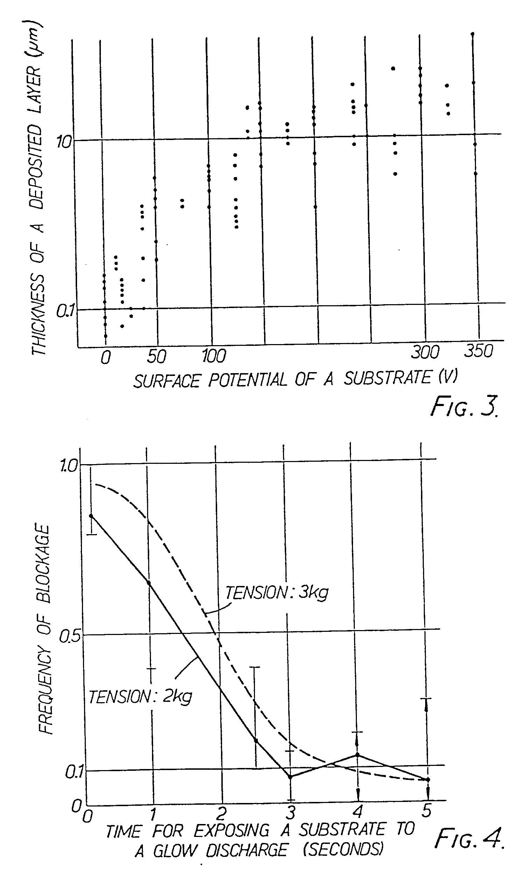

Figure 3 shows the relationship between the surface potential of a substrate film and the maximum thickness of a deposited layer obtainable in a crack free state. The measurements therefor were obtained using polyethylene terenaphthalate film 4 μm thick as a substrate and depositing Ti. In Figure 3 surface potentials from 0 V to 20 V are due to a triboelectricity and those from 50 V to 350 V are caused by the electret state. The curve of maximum thickness saturates at surface potentials above about 150 V. Such a tendency is similar irrespectively of the kind of substrate material, the thickness of substrate, the source material and deposition conditions. A threshold value for obtaining the effect described above i.e. a value corresponding to 50 V in Figure 3, varies according to those conditions. The above-mentioned saturation potential, 150 V, is obtained if the surface roughness of the metal surface used for cooling is smaller than 0.1 μm. The upper limit of the surface potential practically usable is about 600 V.

Hereinafter are described examples of the effect of exposing a substrate film to a glow discharge after deposition and before winding.

Figure 4 shows the relationship between time for exposing the film to the glow discharge and frequency of tearing of the substrate film due to a blockage during unwinding. The frequency is expressed by noting as 1 a case where a blockage occurs once a cycle of winding and unwinding of 500 m length. The deposition conditions used for the measurements were that a 3.5 μm thick polycarbonate film was used as the substrate, the source material was Ti and the surface potential of the substrate was 200 V before the exposure to a glow discharge. It is seen from Figure 4 that the effect of the exposure to a glow discharge is notable. It is also to be noted that the tension of the film has an effect if the exposure time to glow discharge is less than 3 seconds.

Further, differences in the frequency of occurrence of blocking between cases where glow discharge treatment was undertaken and without glow discharge were investigated using the following various conditions for depositing a layer.

Experiment 1
Substrate: polyester; 5 to 12 μm thick
Deposited Layer: Co; 0.05 μm thick
Heating of Source Material: Electron Beam; 16 kW
Film Transport Speed: 25 m/min
Degree of Vacuum: $8 \times 10^{-3}$ Pa

Experiment 2
Substrate: polyimide; 25 μm thick
Deposited Layer: Ti; 0.04 μm
Heating of Source Material: Electron Beam; 16 kW
Film Transport Speed: 16 m/min
Degree of Vacuum: $2 \times 10^{-3}$ Pa
Conditions of glow discharge were as follows:
Pressure Range: 13.3 to $13.3 \times 10^{-3}$ Pa
Frequency: 0 to 44 MHz
Voltage: 10 V peak to peak to 3 kV peak to peak
Current Density: 1 to 600 μA per unit area of an electrode
Introduced Gas: residual gas only, $O_2$, Ar, $N_2$, $Co_2$.

As a result of the above-mentioned experiments, it was found that if a mean surface roughness of the substrate was smaller than about 0.1 μm, blockage occurred in all cases without the glow discharge treatment, though blockage did not occur in the cases with it. When glow discharge treatment was undertaken, blockage did not occur even if the surface roughness of the substrate was 0.01 μm.

As for the conditions for glow discharge, there were no observed significant differences due to differences of conditions except that the supply current density should be controlled according to a transport speed of the substrate film.

## Claims

1. A method for vacuum depositing a layer on a plastics film in which said film is transported so as to pass along a heat conductive surface movable with the film and deposition is carried out in a vacuum chamber in such a manner that a vapour of a source material is emitted to the portion of said film in contact with said heat conductive surface, said source material being heated and evaporated by electron beam bombardment, characterized in that said heat conductive surface has a surface roughness smaller than 0.1 μm and in that said film is made to exhibit an electret state in the vacuum chamber for the deposition process and has a surface potential higher than 150 V when it is in contact with said heat conductive surface, whereby an electrostatic force exists between said film and said heat conductive surface, the energy of said electrons in said electron beam being high enough to cause an electron reflected from said source material to be implanted into the film.

2. A method as claimed in claim 1, in which said heat conductive surface comprises a peripheral surface of a rotatable metal drum.

3. A method as claimed in claim 1, in which said electret state of said films is neutralized after desposition is operated.

4. A method as claimed in claim 3, in which said neutralizing is performed by exposing the surface of the film reserve to the deposited layer to a glow discharge.

## Patentansprüche

1. Verfahren zur Vakuumaufdampfung bzw. -beschichtung einer Schicht auf einem Kunststoffilm, worin der Film so transportiert wird, dass er entlang einer wärmeleitfähigen Oberfläche, die mit dem Film bewegbar ist, passiert und die Aufdampfung in einer Vakuumkammer so durchgeführt wird, dass ein Dampf eines Quellenmaterials zu dem Teil des Films, der in Kontakt mit der wärmeleitfähigen Oberfläche ist, gesandt wird, wobei das Quellenmaterial erwärmt und verdampft wird durch Elektronenbeschuss, dadurch gekennzeichnet, dass die wärmeleitfähige Oberfläche eine Oberflächenrauhheit von weniger als 0,1 μm besitzt und dass der Film so hergestellt wird, dass er einen ferrodielektrischen Zustand in der Vakuumkammer für das Aufdampfungsverfahren aufweist und ein Oberflächenpotential von mehr als 150 V besitzt, wenn er in Kontakt mit der wärmeleitfähigen Oberfläche ist, wodurch eine elektrostatische Kraft zwischen dem Film und der wärmeleitfähigen Oberfläche existiert, wobei die Energie der Elektronen in dem Elektronenstrahl hoch genug ist, um zu bewirken, dass ein Elektron, das aus dem Quellenmaterial reflektiert wird, in den Film eingepflanzt wird.

2. Verfahren nach Anspruch 1, worin die wärmeleitfähige Oberfläche eine Umfangsoberfläche aus einer drehbaren Metalltrommel umfasst.

3. Verfahren nach Anspruch 1, worin der ferrodielektrische Zustand des Films nach der Aufdampfung neutralisiert wird.

4. Verfahren nach Anspruch 3, worin das Neutralisieren durchgeführt wird, indem die der aufgedampften Schicht gegenüberliegende Oberfläche des Films einer Glimmentladung ausgesetzt wird.

## Revendications

1. Méthode de dépôt sous vide d'une couche de revêtement sur un film de matière plastique, dans laquelle ledit film est transporté de façon à passer le long d'une surface conductrice de la chaleur qui est mobile avec le film et dans laquelle le dépôt s'effectue dans une chambre sous vide de façon que la vapeur d'un matériau source soit émise en direction de la portion dudit film qui est en contact avec ladite surface conductrice de la chaleur, ledit matériau source étant chauffé et évaporé par bombardement à l'aide d'un faisceau électronique, caractérisée en ce que ladite surface conductrice de la chaleur présente une rugosité de surface inférieure à 0,1 µm, et en ce que ledit film est fait de manière à présenter un état d'électret dans la chambre sous vide servant au processus de dépôt et possède un potentiel de surface supérieur à 150 V lorsqu'il est au contact de ladite surface conductrice de la chaleur, si bien qu'il existe une force électrostatique entre ledit film et ladite surface conductrice de la chaleur, l'énergie des électrons dudit faisceau électronique étant suffisante pour qu'un électron réfléchi par ledit matériau source s'implante dans le film.

2. Méthode selon la revendication 1, dans laquelle ladite surface conductrice de la chaleur comporte la surface périphérique d'un tambour métallique tournant.

3. Méthode selon la revendication 1, dans laquelle ledit état d'électret dudit film est neutralisé après que le dépôt a été effectué.

4. Méthode selon la revendication 3, dans laquelle ladite neutralisation s'effectue par soumission à une décharge luminescente de la surface du film opposée au revêtement déposé.

FIG. I.

FIG.2A.

FIG.2B.

FIG. 3.

FIG. 4.